# EUROPEAN PATENT APPLICATION

(11) **EP 1 892 709 A2**
(43) Date of publication of application: **27.02.2008**
(21) Application number: 07253198.1
(22) Date of filing: 15.08.2007
(51) Int. Cl.: G11B 9/00, G11C 11/22

(54) **Devices and methods for writing and reading information**

(30) Priority: 24.08.2006 US 823411 P
(71) Applicant: Rohm and Haas Company, Philadelphia, PA 19106-2399 (US)
(72) Inventor: Bu, Lujia, Holden, Massachusetts 01520 (US); Greer, Edward C., Lower Gwynedd, Pennsylvania 19002 (US); Szmanda, Charles R., Westborough, Massachusetts 01581 (US)
(74) Representative: Buckley, Guy Julian

(57) **Abstract**

Memory devices and methods of storing information are disclosed. Also disclosed are methods of storing information in multi-bit format and memory devices with information stored in multi-bit format. Further disclosed are methods of reading stored information.

## Description

The present invention relates to methods of writing information to an electric field programmable film. The present invention also relates to methods of reading the stored information. The present invention further relates to devices using the methods of the present invention.

Scanning probe microscopy is a widely used technology for analyzing material surfaces at the atomic level. A conventional example of a scanning probe microscope is an atomic force microscope (AFM) that uses a probe or stylus having a microfabricated tip mounted on a flexible cantilever. This tip is typically produced from Si₃N₄ or Si. In operation, the probe or stylus is slowly scanned across the surface of a material. In some applications, the probe or stylus is maintained at a distance of a few angstroms away from the surface of the material, i.e., in non-contact mode. In some applications, the probe or stylus is maintained in contact with the surface of the material, i.e., in contact mode. The force imparted between the atoms on the surface of the material and those on the tip is indicative of certain properties of the surface of the material and can be measured. For example, in some applications, this force causes the probe or stylus to move relative to the surface of the material. The direction and magnitude of the movement can be detected and measured. The most common technique for detection/measurement of the movement uses a laser focused on the top of the cantilever and reflected onto photodetectors. The photodetector signals are used to map a given property of the surface of the material with resolutions down to the atomic and nano scales. In such devices, the lateral and vertical movements of the probe or stylus relative to the sample are controlled using piezoelectric transducers and a feedback loop that produces voltage differences proportional to the movement.

Apparatus and methods for storing binary data with high data capacities are disclosed in U.S. Patent Application Publication No. 2004/0257887 to Binnig et al. Binnig et al. disclose an apparatus comprising a tape having an information layer on which information is storable in the form of perturbations, an array of probes that in function faces the tape such that the probes scan the surface of the tape, means for selectively forming the perturbations via the probes, means for detecting the presence of the perturbations via the probes, and drive means for moving the tape relative to the array of probes.

Notwithstanding, a need still exists for new methods of writing and reading information and for memory devices using such new methods.

In one aspect of the present invention, there is provided a method for storing information in an electric field programmable film, comprising: providing an electric field programmable film having a top surface and a bottom surface, writing information to the electric field programmable film by applying a write voltage across the electric field programmable film from the top surface to the bottom surface using at least one stylus, wherein the write voltage induces an enduring domain of polarization within the electric field programmable film; and, wherein the electric field programmable film includes at least two available information states, where each available information state corresponds to a different polarization.

In another aspect of the present invention, there is provided a method for storing information in an electric field programmable film device, comprising: providing a substrate; providing an electric field programmable film having a top surface and a bottom surface, wherein the bottom surface is electrically coupled to the substrate, wherein the electric field programmable film comprises one or more portions, wherein each portion corresponds to a memory location having at least two available information states, wherein each available information state corresponds to a different polarization of the electric field programmable film; providing at least one stylus; writing information to at least one memory location by applying a write voltage between the stylus and the substrate at the at least one memory location, wherein the write voltage induces an enduring domain of polarization within the electric field programmable film.

In another aspect of the present invention, there is provided a memory device, comprising: an electric field programmable film, wherein the electric field programmable film comprises a multiplicity of individual mapped portions corresponding to a multiplicity of individual memory locations; wherein the memory device contains information stored as multi-bit information.

In another aspect of the present invention, there is provided a method for reading information stored in an electric field programmable film, comprising: providing an electric field programmable film containing information stored in at least one memory location, wherein the electric field programmable film includes at least two available information states, where each available information state corresponds to a different polarization; providing at least one stylus; determining the information state of at least one memory location by measuring the force between the stylus and the electric field programmable film corresponding to the at least one memory location.

### DETAILED DESCRIPTION

The terms "**electrical coupling**" as used herein and in the appended claims encompasses ohmic contact, capacitive coupling and/or inductive coupling.

The term "**chemically bonded**" as used herein and in the appended claims encompasses covalently bonded, ionically bonded and hydrogen bonded.

The term "**derivatives**" as used herein and in the appended claims, in reference to an electron donor or an electron acceptor, encompasses chemical modifications and analogs of the referenced electron donor or electron acceptor such as, for example, isomers, chemical substitutions, and instances in which the electron donor or electron acceptor is chemically bonded to a binder or incorporated into the binder as a monomer unit.

The term "**information**" as used herein and in the appended claims encompasses user data, encoded user data (e.g., user data encoded for compression purposes), device "housekeeping" data such as servo data, track or sector information, feedback signals, clock signals, or data regarding the position of the stylus and/or substrate, and user data and/or encoded user data combined with another source of data (e.g., error checking, correction bits, or device "housekeeping" data).

The terms "**ground signal**" and "**ground potential**" as used herein and in the appended claims means a relative voltage against which the subject voltage is applied. The ground signal or ground potential may be "earth ground", logic ground, or any other arbitrary applied voltage, whether constant in time, varying in time or combinations thereof.

The "**polarization**" of the electric field programmable film, as that term is used in the specification and appended claims, is a vector quantity that implies both a direction and a magnitude. In some embodiments of the present invention, polarization is used to store multi-bit information.

The term "**multi-bit information**" as used herein and in the appended claims means information stored using more than two available information states per memory location.

In some embodiments of the present invention, the at least one stylus is operatively associated with a cantilever. Cantilevers for use in association with styli are well known structural elements that are available in commerce. In some aspects of these embodiments, the cantilevers are prepared using existing fabrication techniques. One of ordinary skill in the art will recognize how to adapt cantilevers to the special requirements for a given application by altering cantilever parameters such as materials of construction, resonant frequency, force constant, length, width, plasticity, electrical susceptibility, magnetic susceptibility, front side coating, back side coating, level of impurity doping, electrical resistivity, thickness, tip diameter, coating material, flexibility, tip geometry (isotropic or anisotropic), tip height, front angle, back angle, side angle, tilt, spike height, spike width, overhang and effective neck.

In some embodiments of the present invention, the stylus is operated in static mode.

In some embodiments of the present invention, the stylus is operated in dynamic mode.

In some embodiments of the present invention, the at least one stylus is an array of styli associated with a cantilever array. In some aspects of these embodiments, the cantilever array is fabricated by etching away portions of a silicon substrate. In some aspects of these embodiments, the silicon substrate is wet etched using ethyl diamine pyrocatechol or KOH solutions. Those skilled in the art will recognize that wet etching techniques are typically dependent on crystallographic orientation of the substrate, which facilitates a good etch stop along the crystallographic axis generating well defined etch planes. In some aspects of these embodiments, the silicon substrate is dry etched. In some aspects of these embodiments, reactive-ion beam etching techniques are used. In some aspects of these embodiments, chemically assisted ion beam etching techniques are used. In some aspects of these embodiments, microwave assisted plasma etching techniques are used. In some aspects of these embodiments, the cantilevers exhibit a cross-sectional shape selected from rectangular, round, elliptical, polygonal and combinations thereof. In some aspects of these embodiments, the cantilevers are prepared from a material selected from silicon and gallium arsenide.

In some embodiments of the present invention, the at least one stylus has a tip. In some aspects of these embodiments, the tip is formed by isotropic wet or dry etching in combination with the oxidation of a single crystal material. In some aspects of these embodiments, the single crystal material is silicon. In some aspects of these embodiments, the materials used to produce the at least one stylus are selected from tungsten, tungsten alloys, platinum, molybdenum, doped silicon, undoped silicon, doped diamond, refractory metals and conductive ceramics. In some aspects of these embodiments, a combination of wet or dry etching and liftoff plus oxidation is used to provide very sharp pointed cone shaped tips. Those skilled in the art will recognize that the sharper the tips, the more densely information can be stored and the higher the storage capacity for a given device.

In some embodiments of the present invention, the at least one stylus is coated with a metal. In some aspects of these embodiments, the at least one stylus is coated with gold.

In some embodiments of the present invention, the at least one stylus is operatively associated with electronics that facilitate the writing of information to an electric field programmable film.

In some embodiments of the present invention, the at least one stylus is operatively associated with electronics that facilitate the reading of information stored on an electric field programmable film.

In some embodiments of the present invention, the at least one stylus is operatively associated with electronics selected from driving circuitry, preamplifiers, wires and combinations thereof.

One skilled in the art will know how to employ existing tools and processes common to the semiconductor and solid-state industries to provide the circuitry needed to write and read information in accordance with the methods of the present invention. In some embodiments of the present invention, the at least one stylus is operatively associated with electronics like that used in scanning tunneling microscopy (STM) systems and atomic force microscopy (AFM) systems. In some aspects of these embodiments, the at least one stylus is operatively associated with scanning tunneling microscopy system electronics. In some aspects of these embodiments, the at least one stylus is operatively associated with atomic force microscopy system electronics.

In some embodiments of the present invention, the electric field programmable film is partitioned, divided, and/or mapped into portions defining memory locations for information storage. In some aspects of these embodiments, the memory locations are defined physically, logically, or by a combination thereof. In some aspects of these embodiments, information is stored in individual memory locations through manipulation of the polarization of the electric field programmable film corresponding to the individual memory locations. One of ordinary skill in the art will recognize that the more densely the electric field programmable film is partitioned, the higher the storage density. Notwithstanding, those of ordinary skill in the art will also recognize that maintaining a certain distance between neighboring memory locations helps to ensure that the information stored in these neighboring memory locations remains distinguishable.

In some embodiments of the present invention, there is provided a memory device comprising an electric field programmable film and at least one stylus, wherein the at least one stylus addresses a single mapped portion of the electric field programmable film.

In some embodiments of the present invention, there is provided a memory device comprising an electric field programmable film and at least one stylus, wherein the at least one stylus addresses a plurality of mapped portions of the electric field programmable film.

In some embodiments of the present invention, the electric field programmable film has a multiplicity of mapped memory locations. In some aspects of these embodiments, the memory locations are mapped physically and/or logically. In some aspects of these embodiments, the memory locations are defined lithographically. In some aspects of these embodiments, fiducial registration indicia provide global or piecewise alignment. In some aspects of these embodiments, the indicia are indentations in the electric field programmable film. In some aspects of these embodiments, the indentations are formed using at least one stylus. In some aspects of these embodiments, the indentations are formed using at least one stylus at a temperature below the softening point temperature of the electic field programmable film.

In some embodiments of the present invention, the electric field programmable film is divided into portions comprising substantially parallel tracks.

In some embodiments of the present invention, the electric field programmable film is divided into portions comprising one or more spiral tracks.

In some embodiments of the present invention, the electric field programmable film is divided into portions comprising concentric, substantially circular tracks.

In some embodiments of the present invention, the electric field programmable film is moveable back and forth in a direction parallel to a first axis. In some aspects of these embodiments, the electric field programmable film is also moveable back and forth in a direction perpendicular to the first axis. In some aspects of these embodiments, the at least one stylus is scanned across a first row of memory locations parallel to the first axis, the at least one stylus is then step-wise moved in a direction perpendicular to the first axis and then the at least one stylus is scanned across a second row of memory locations parallel to the first axis and so on. In some aspects of these embodiments, the memory locations are scanned using a basket-weave scheme. In some aspects of these embodiments, a pulsed scanning scheme is used. In some aspects of these embodiments, a continuous scanning scheme is used.

In some embodiments of the present invention, the at least one stylus is associated with structures in or on the electric field programmable film, which structures facilitate tracking of the at least one stylus relative to the electric field programmable film. In some aspects of these embodiments, tracking is achieved using mechanical means that guide the at least one stylus along a predefined path. In some aspects of these embodiments, the tracking is achieved using optical or other contactless means. In some aspects of these embodiments, deflection sensors associated with the at least one stylus are arranged to interact with counterpart structures associated with the electric field programmable film to facilitate precise movement of the at least one stylus and the electric field programmable film relative to one another. In some aspects of these embodiments, tracking marks are used to establish the boundaries of the electric field programmable film. In some aspects of these embodiments, the tracking marks are used to trigger changes in the direction of movement of the at least one stylus and the electric field programmable film relative to one another.

In some embodiments of the present invention, actuators are employed to move the at least one stylus and the electric field programmable film relative to one another. In some aspects of these embodiments, the at least one stylus has an actuator to facilitate its movement across the electric field programmable film. In some aspects of these embodiments, the at least one stylus is a stylus array. In some aspects of these embodiments, the at least one stylus is a plurality of stylus arrays, wherein each stylus array has its own actuator to facilitate its movement across the electric field programmable film. In some aspects of these embodiments, the actuators comprise actuator wiring and actuator driving circuitry.

In some embodiments of the present invention, each cantilever has its own actuator for displacing it from a relaxed position to a deflected position or vice versa. In some aspects of these embodiments, the displacement achieved using the actuator is dampened.

In some embodiments of the present invention, each cantilever has its own actuator which can provide displacement of the stylus in multiple planes. In some aspects of these embodiments, the actuator is a piezoelectric actuator or a transducer. In some aspects of these embodiments, the at least one stylus is an array of individually moveable styli, wherein as the array of styli, as a whole, is scanned across the electric field programmable film, each individually moveable stylus is further scanned across a subarea within reach of its range of individual moveability.

In some embodiments of the present invention, the at least one stylus is associated with a coarse actuator that facilitates macroscopic distance adjustments of the at least one stylus relative to the electric field programmable film. In some aspects of these embodiments, a coarse actuator is employed to facilitate movement of the at least one stylus into proximity with the electric field programmable film and fine actuators associated with an individual cantilever(s) associated with the at least one stylus facilitate gap control during writing and reading operations. In some aspects of these embodiments, the coarse actuator is used to move the at least one stylus between a park position when idle and a write or read position when writing or reading.

In some embodiments of the present invention, coarse actuators are selected from piezoelectric ceramic material actuators and lead zirconate titanate actuators.

In some embodiments of the present invention, coarse actuators comprise precision levers and micrometer screws.

In some embodiments of the present invention, the coarse actuators comprise coarse actuator driving circuitry. In some aspects of these embodiments, the coarse actuator driving circuitry is integrated into the memory device. In some aspects of these embodiments, the coarse actuator driving circuitry is not integrated into the memory device.

In some embodiments of the present invention, the at least one stylus is operatively associated with write/read electronics. In some aspects of these embodiments, the write/read electronics include at least one of a microprocessor, encoder/decoder, compensator, automatic gain control, filter/equalizer, data detector, discriminator/quantizer, multiplexer/demultiplexer, parallel-to-serial converter, serial-to-parallel converter, digital to analog converter and analog to digital converter. In some aspects of these embodiments, the write/read electronics include error correction means. In some aspects of these embodiments, the write/read functions are performed using a single integrated microprocessor that coordinates all the activities of the memory device. In some aspects of these embodiments, the write/read functions are performed using a microprocessor of a computer to which the memory device is interfaced.

In some embodiments of the present invention, the electric field programmable film is provided as either a continuous layer or a pixelated layer. In some aspects of these embodiments, the electric field programmable film has a top surface and a bottom surface, wherein the top surface and the bottom surface are substantially parallel.

In some embodiments of the present invention, the electric field programmable film comprises a binder, an electron donor and an electron acceptor. In some aspects of these embodiments, the electron donor comprises a combination of electron donors. In some aspects of these embodiments, the electron acceptor comprises a combination of electron acceptors. In some aspects of these embodiments, the electron donor and the electron acceptor comprise a donor-acceptor complex. In some aspects of these embodiments, the electric field programmable film further comprises a donor-acceptor complex.

In some embodiments, the binder exhibits a dielectric constant of 2 to 1,000. In some aspects of these embodiments, the methods of the present invention further comprise selecting a fundamentally non-conductive binder having a dielectric constant of 2 to 1,000.

In some embodiments, the binder exhibits sufficient chemical and thermal resistance to withstand processes involving the deposition of metals, etch barrier layers, seed layers, metal precursors, photoresists and antireflective coatings.

In some embodiments of the present invention, the binder is selected from, for example, oligomers; polymers; ionomers; dendrimers; copolymers such as block copolymers, random copolymers, graft copolymers, star block copolymers; inorganics, partial inorganics; organometallics and combinations thereof. In some aspects of these embodiments, the binder is selected from organic polymers, inorganic polymers and combinations thereof. In some aspects of these embodiments, the binder is an organic polymer. In some aspects of these embodiments, the binder is an inorganic polymer. In some aspects of these embodiments the binder comprises organic and inorganic groups.

In some embodiments of the present invention, the binder is chemically bonded, alternatively covalently bonded, to at least one of the electron donor(s) and/or at least one of the electron acceptor(s). In some aspects of these embodiments, the at least one of the electron donor(s) and/or the at least one of the electron acceptor(s) is chemically bonded to the binder. In some aspects of these embodiments, the at least one of the electron donor(s) and/or the at least one of the electron acceptor(s) is covalently bonded to the binder.

In some embodiments of the present invention, the binder is selected from polymers including, for example, polyacetals, polyacrylics, polycarbonates, polystyrenes, polyesters, polyamides, polyamideimides, polyarylates, polyarylsulfones, polyethersulfones, polyphenylene sulfides, polysulfones, polyimides, polyetherimides, polytetrafluoroethylenes, polyetherketones, polyether etherketones, polyether ketone ketones, polybenzoxazoles, polyoxadiazoles, polybenzothiazinophenothiazines, polybenzothiazoles, polypyrazinoquinoxalines, polypyromellitimides, polyquinoxalines, polybenzimidazoles, polyoxindoles, polyoxoisoindolines, polydioxoisoindolines, polytriazines, polypyridazines, polypiperazines, polypyridines, polypiperidines, polytriazoles, polypyrazoles, polycarboranes, polyoxabicyclononanes, polydibenzofurans, polyphthalides, polyacetals, polyanhydrides, polyvinyl ethers, polyvinyl thioethers, polyvinyl alcohols, polyvinyl ketones, polyvinyl halides, polyvinyl nitriles, polyvinyl esters, polysulfonates, polysulfides, polythioesters, polysulfones, polysulfonamides, polyureas, polyphosphazenes, polysilazanes, polysiloxanes, and combinations thereof.

In some embodiments of the present invention, the binder may be a copolymer selected from, for example, copolyestercarbonates, acrylonitrile butadiene styrene, styrene acrylonitrile, polyimide-polysiloxane, polyester-polyetherimide, polymethylmethacrylate-polysiloxane, polyurethane-polysiloxane, and combinations thereof.

In some embodiments of the present invention, the binder is selected from mixtures of polymers. In some aspects of these embodiments the polymers are crosslinkable. In some aspects of these embodiments, the binder comprises at least two polymers, wherein one of the at least two polymers is chemically bound, alternatively covalently bound, to an electron donor and/or an electron acceptor and wherein one of the at least two polymers is not chemically bound, alternatively covalently bound, to either an electron donor or an electron acceptor. In some aspects of these embodiments, the binder comprises at least two polymers, wherein one of the at least two polymers is chemically bound, alternatively covalently bound, to an electron donor and another one of the at least two polymers is chemically bound, alternatively covalently bound, to an electron acceptor. Such mixtures of polymers may be employed to fine tune the properties of the electric field programmable film. For example, the polymer mixture may be used to balance the charge carrier density in a given electric field programmable film composition.

In some embodiments of the present invention, the binder is a mixture of polymers. In some aspects of these embodiments, the binder is selected from a mixture of polymers selected from, for example, acrylonitrile-butadiene-styrene/nylon, polycarbonate/acrylonitrile-butadiene-styrene, acrylonitrile butadiene styrene/polyvinyl chloride, polyphenylene ether/polystyrene, polyphenylene ether/nylon, polysulfone/acrylonitrile-butadiene-styrene, polycarbonate/thermoplastic urethane, polycarbonate/polyethylene terephthalate, polycarbonate/polybutylene terephthalate, thermoplastic elastomer alloys, nylon/elastomers, polyester/elastomers, polyethylene terephthalate/polybutylene terephthalate, acetal/elastomer, styrene-maleicanhydride/acrylonitrile-butadiene-styrene, polyether etherketone/polyethersulfone, polyethylene/nylon, polyethylene/polyacetal, and combinations thereof.

In some embodiments of the present invention, the binder is an inorganic or partially inorganic material. In some aspects of these embodiments, the binder comprises a silicone, silsesquioxane and combinations thereof. In some aspects of these embodiments, the binder comprises a silicone or a silsesquioxane. In some aspects of these embodiments, the binder comprises a silicone or a silsesquioxane wherein the silicone or silsesquioxane is chemically bound, alternatively covalently bound, to an electron donor or an electron acceptor or combinations thereof.

In some embodiments of the present invention, the binder is functionalized to facilitate at least one of crosslinking, chemical bonding with an electron donor, chemical bonding with an electron acceptor, covalent bonding with an electron donor and covalent bonding with an electron acceptor. In some embodiments of the present invention, the binder is a polymer or combination of polymers having a number average molecular weight of 500 to 1,000,000 grams/mole. In some embodiments of the present invention, the binder is a polymer or combination of polymers having a number average molecular weight of 3,000 to 500,000 grams/mole. In some embodiments of the present invention, the binder is a polymer or combination of polymers having a number average molecular weight of 5,000 to 100,000 grams/mole. In some embodiments of the present invention, the binder is a polymer or combination of polymers having a number average molecular weight of 10,000 to 30,000 grams/mole.

In some embodiments of the present invention, the binder may be crosslinked. In some aspects of these embodiments, the crosslinking may be brought about by reactions at functional groups chemically bonded, alternatively covalently bonded, to the backbone of the binder. In some aspects of these embodiments, the crosslinking may occur through non-covalent bonding. In some aspects of these embodiments, the binder may be crosslinked using a crosslinking agent including, for example, a silane, an ethylenically unsaturated resin, an aminoplast resin, a phenolic, a phenol-formaldehyde resin, an epoxy, and combinations thereof.

In some embodiments of the present invention, the electric field programmable film composition comprises a crosslinking agent. In some aspects of these embodiments, the electric field programmable film composition comprises 0.01 to 20 wt% crosslinking agents (based on total solids). In some aspects of these embodiments, the electric field programmable film composition comprises 0.1 to 15 wt% crosslinking agents (based on total solids). In some aspects of these embodiments, the electric field programmable film composition comprises 0.5 to 10 wt% crosslinking agents (based on total solids). In some aspects of these embodiments, the electric field programmable film composition comprises 1 to 7 wt% crosslinking agents (based on total solids).

In some embodiments of the present invention, the electric field programmable film composition comprises an, optional, acid and/or acid generator. The addition of an acid and/or an acid generator may catalyze or promote crosslinking of the binder during curing of the electric field programmable film composition. In some aspects of these embodiments, the acid is selected from, for example, aromatic sulfonic acids (e.g., toluene sulfonic acid, benzene sulfonic acid, p-dodecylbenzene sulfonic acid); fluorinated alkyl or aromatic sulfonic acids (e.g., o-trifluoromethylbenzene sulfonic acid, triflic acid, perfluoro butane sulfonic acid, perfluoro octane sulfonic acid); and combinations thereof. In some aspects of these embodiments, the acid generator is a thermal acid generator selected from, for example, 2,4,4,6-tetrabromocyclohexadienone; benzoin tosylate; 2-nitrobenzyl tosylate; 4-nitrobenzyl tosylate; and combinations thereof. In some aspects of these embodiments, the electric field programmable film composition comprises 0.01 to 10 wt% acid generator (based on total solids). In some aspects of these embodiments, the electric field programmable film composition comprises 0.1 to 8 wt% acid generator (based on total solids). In some aspects of these embodiments, the electric field programmable film composition comprises 0.5 to 5 wt% acid generator (based on total solids). In some aspects of these embodiments, the electric field programmable film composition comprises 1 to 3 wt% acid generator (based on total solids).

In some embodiments of the present invention, the electron donor(s) are selected from, for example, anthracene; tetrathiafulvalene; 4,4',5-trimethyltetrathiafulvalene; bis(ethylenedithio)tetrathiafulvalene; p-phenylenediamine; carbazole; substituted carbazole (e.g., N-vinyl carbazole); tetrathiotetracene; hexamethylbenzene; tetramethyltetraselenofulvalene; hexamethylenetetraselenofulvalene; 8-hydroxyquinoline; phenyl azorecorcinol and similar azo dyes; N,N'-bis(3-methylphenyl)-N,N'-diphenylbenzidine; phenothiazine; substituted phenothiazines (e.g., N-vinyl phenothiazine); pyrene; acenaphthylene; acridine; triphenylene; phthalocyanine; 2-amino-1H-imidazole-4,5-dicarbonitrile (AIDCN); substituted AIDCN (e.g., N-vinyl AIDCN); derivatives thereof; and combinations thereof.

In some embodiments of the present invention, the electron donor(s) are an electron donor derivative chemically bound to a binder (hereinafter and in the claims represented by "electron donor derivative-binder"). In some aspects of these embodiments, the electron donor derivative-binder is selected from, for example, 9-anthracenemethyl methacrylate/2-hydroxyethyl methacrylate/3-(trimethoxysilyl)propyl methacrylate terpolymer; a quinolin-8-yl methacrylate/2-hydroxyethyl methacrylate copolymer; a 9-anthracenemethyl methacrylate/2-hydroxyethyl methacrylate copolymer; a quinolin-8-yl methacrylate/2-hydroxyethyl methacrylate/3-(trimethoxysilyl)propyl methacrylate terpolymer; a 9-anthracenemethyl methacrylate; a quinolin-8-yl methacrylate; and combinations thereof.

In some embodiments of the present invention, the electron acceptor(s) are selected from, for example, pentafluoroaniline; phthalocyanine; perfluorophthalocyanine; tetraphenylporphine; 2-(9-dicyanomethylene-spiro[5.5]undec-3-ylidene)-malononitrile; 4-phenylazo-benzene-1,3-diol; 4-(pyridin-2-ylazo)-benzene-1,3-diol; benzo[1,2,5]thiadiazole-4,7-dicarbonitrile; tetracyanoquinodimethane; quinoline; chlorpromazine; fullerene C₆₀ (e.g., Buckminsterfullerene C₆₀); fullerene C₇₀ (e.g., Buckminsterfullerene C₇₀); perylene-3,4:9,10-tetracarboxydiimide; trinitrobenzene; 2-(3-Nitro-benzilidene)-malononitrile; hexacyanobutadiene; anhydrides; derivatives and combinations thereof. In some aspects of these embodiments, the electron acceptor(s) are selected from fullerene C₆₀; fullerene C₇₀; derivatives thereof; and combinations thereof.

In some embodiments of the present invention, the electron acceptor(s) are selected from, for example, anhydrides, dianhydrides, imides and diimides (e.g., phthalic, especially those with 4 halogens on the ring; pyromellitic dianhydride; naphthalene-tetracaboxylic-dianhydride (NTCDA); perylene-tetracarboxylic-dianhydride (PTCDA)); benzoquinones (e.g., tetra-halogenated and tetracyano derivatives); naphthoquinones; anthraquinones; cyano-compounds (e.g., tetracyanoethylene (TCNE), tetracyanoquinodimethane (TCNQ), AIDCN); nitro compounds having at least three nitro groups (e.g., benzenes, naphthalenes, trinitrofluorenone, nitrated dibenzothiophenedioxide, nitrated phenylsulfones); poly-sulfones (e.g., 1,4-bis(phenylsulfonyl)benzene); viologens; viologen salts; 1,3,5-triazines (e.g., halogen and cyano derivatives thereof); alpha diketones (e.g., indanetrione); sulfur; derivatives; and combinations thereof.

In some embodiments of the present invention, the electric field programmable film composition comprises < 1 wt%; or < 0.5 wt%; or ≤ 0.4 wt%; or ≤ 0.3 wt%; or ≤ 0.25 wt%; or ≤ 0.2 wt%; or ≤ 0.1 wt%; or ≤ 0.09 wt%; or ≤ 0.075 wt%; or ≤ 0.05 wt% electron donor(s) (based on total solids).

In some embodiments of the present invention, the electric field programmable film composition comprises < 1 wt%; or < 0.5 wt%; or ≤ 0.4 wt%; or ≤ 0.3 wt%; or ≤ 0.25 wt%; or ≤ 0.2 wt%; or ≤ 0.1 wt%; or ≤ 0.09 wt%; or ≤ 0.075 wt%; or ≤ 0.05 wt% electron acceptor(s) (based on total solids).

In some embodiments of the present invention, either the electron donor(s) or the electron acceptor(s) are provided in relative excess. In some aspects of these embodiments, the electric field programmable film composition will contain a higher concentration of electron donor(s) relative to the concentration of electron acceptor(s). In some aspects of these embodiments, the electric field programmable film composition will contain a higher concentration of electron acceptor(s) relative to the concentration of electron donor(s). In some aspects of these embodiments, the concentration of the electron donor(s) in the electric field programmable film composition is 0.002 to 0.1 µmol/hg; or 0.005 to 0.1 µmol/hg; or 0.005 to 0.05 µmol/hg; or 0.01 to 0.05 µmol/hg; and the concentration of the electron acceptor(s) in the electric field programmable film composition is 10 to 300 µmol/hg; or 10 to 200 µmol/hg; or 10 to 150 µmol/hg; or 25 to 125 µmol/hg; or 25 to 100 µmol/hg; or 50 to 100 µmol/hg. In some aspects of these embodiments, the concentration of the electron acceptor(s) in the electric field programmable film composition is 0.002 to 0.1 µmol/hg; or 0.005 to 0.1 µmol/hg; or 0.005 to 0.05 µmol/hg; or 0.01 to 0.05 µmol/hg; and the concentration of the electron donor(s) in the electric field programmable film composition is 10 to 300 µmol/hg; or 10 to 200 µmol/hg; or 10 to 150 µmol/hg; or 25 to 125 µmol/hg; or 25 to 100 µmol/hg; or 50 to 100 µmol/hg. The selection of whether to provide electron donor(s) or electron acceptor(s) in relative excess depends on the specific electron acceptor(s) and electron donor(s) used.

In some embodiments of the present invention, the electron acceptor(s) is selected from molecules or derivatives that exhibit an electron affinity > 0.8 eV, alternatively >1.2 eV. In some aspects of these embodiments, the selection of the optimum electron acceptor is influenced by its ionization potential. In some aspects of these embodiments, at least two electron acceptors are used.

In some embodiments of the present invention, the electron donor(s) is selected from molecules or derivatives that exhibit an ionization potential < 8.5 eV; alternatively < 8.0 eV. In some aspects of these embodiments, the selection of the optimum electron donor(s) is influenced by its ionization potential. In some aspects of these embodiments, at least two electron donors are used.

In some embodiments of the present invention, the total molar electron donor concentration exceeds the total molar electron acceptor concentration by a factor of ≥ 10; or ≥ 100; or ≥ 1,000; or ≥ 10,000.

In some embodiments of the present invention, the total molar electron acceptor concentration exceeds the total molar electron donor concentration by a factor of ≥ 10; or ≥ 100; or ≥ 1,000; or ≥ 10,000.

In some aspects of these embodiments, the electron donor atomic or molecular concentration is 10¹⁴-10²¹ (atoms or molecules)/cm³, alternatively 10¹⁶-10¹⁹ (atoms or molecules)/cm³. In some aspects of these embodiments, the electron acceptor atomic or molecular concentration is 10¹⁴-10²¹ (atoms or molecules)/cm³, alternatively 10¹⁶-10¹⁹ (atoms or molecules)/cm³.

Note that some molecules or derivatives have an electron affinity and ionization potential such that they may function as either an electron donor or an electron acceptor depending on the selection of the other components of the electric field programmable film composition (e.g., phthalocyanine). Without wishing to be bound by theory, in comparing molecules or derivatives, the molecules or derivatives with the lower ionization potential(s) is usually considered to be the electron donor(s), while those with the higher electron affinity(ies) is considered the electron acceptor(s).

In some embodiments of the present invention, the electric field programmable film composition further comprises an optional donor-acceptor complex, which operates to adjust the properties of the film, for example, the voltages required to set the film to a given available information state. In some aspects of these embodiments, the electric field programmable film composition contains 0.05 to 5 wt%, or 0.5 to 4 wt%, or 1 to 3.5 wt%, or 1.5 to 3 wt% of the optional donor-acceptor complex. In some aspects of these embodiments, the electric field programmable film composition comprises an optional donor-acceptor complex selected from, for example, tetrathiafulvalene--tetracyanoquinodimethane; hexamethylenetetrathiafulvalene--tetracyanoquinodimethane; tetraselenafulvalene--tetracyanoquinodimethane; hexamethylenetetraselenafulvalene--tetracyanoquinodimethane; methylcarbazole--tetracyanoquinodimethane; tetramethyltetraselenofulvalene--tetracyanoquinodimethane; ferrocene--tetracyanoquinodimethane; (tetrathiotetracene, tetramethyl-p-phenylenediamine, or hexamethylbenzene)--tetracyanoquinodimethane; (tetrathiafulvalene, hexamethylenetetrathiafulvalene, tetraselenafulvalene, hexamethylenetetraselenafulvalene, or tetramethyltetraselenofulvalene)--N-alkylcarbazole(C₁-C₁₀, linear or branched); (tetrathiotetracene, tetramethyl-p-phenylenediamine, or hexamethylbenzene)--Buckminsterfullerene C₆₀; (tetrathiotetracene, tetramethyl-p-phenylenediamine, or hexamethylbenzene)--Buckminsterfullerene C₇₀; (tetrathiotetracene, tetramethyl-p-phenylenediamine, or hexamethylbenzene)--tetracyanobenzene; (tetrathiotetracene, tetramethyl-p-phenylenediamine, or hexamethylbenzene)--tetracyanoethylene; (tetrathiotetracene, tetramethyl-p-phenylenediamine, or hexamethylbenzene)--p-chloranil; and combinations thereof.

In some embodiments of the present invention, an electron donor and an electron acceptor are provided as a donor-acceptor complex or form a donor-acceptor complex *in-situ* when added to a binder. In some aspects of these embodiments, the extent to which electron donors and electron acceptors form donor-acceptor complexes ***in-situ*** depends on the law of mass action. In some aspects of these embodiments, the donor-acceptor complexes disproportionate *in-situ* when added to a binder, resulting.in non-ionized electron donors and electron acceptors.

In some embodiments of the present invention, the electric field programmable film composition optionally contains processing agents including, for example, surfactants, mold release agents, accelerators, anti-oxidants, thermal stabilizers, anti-ozonants, fillers and fibers.

The electric field programmable film can be manufactured by a variety of conventional methods. For example, in one method, an electric field programmable film composition of the present invention is deposited on a substrate. The deposited film composition is then dried and/or cured to form the electric field programmable film. In another method, the electric field programmable film composition comprises an optional solvent. The electric field programmable film is then cast from the electric field programmable composition as the solvent is evaporated. Some methods for casting the film include, for example, spin coating, spray coating, electrostatic coating, dip coating, blade coating and slot coating. In another method, the electric field programmable film is manufactured by processes including, for example, injection molding, vacuum forming, blow molding, compression molding, and printing processes (e.g., inkjet, offset, intaglio, screen, and gravure).

Substrates suitable for use with the present invention include, for example, semiconducting substrates (e.g., doped silicon wafers) and conducting substrates (e.g., aluminum, titanium, vanadium, chromium, manganese, iron, cobalt, nickel, copper, zinc, zirconium, niobium, molybdenum, ruthenium, rhodium, palladium, silver, cadmium, hafnium, tantalum, tungsten, rhenium, osmium, iridium, platinum, gold mercury, tin, germanium, lead, and alloys thereof). In some embodiments of the present invention, at least one of the substrate and the electric field programmable film is patterned.

In some embodiments of the present invention, the at least one stylus is a voltage biased stylus. In some aspects of these embodiments, the at least one stylus is a voltage biased atomic force microscopy probe.

In some embodiments of the present invention, the at least one stylus has associated electronics and structure to facilitate writing information to the electric field programmable film and reading information written to the electric field programmable film. In some aspects of these embodiments, the associated electronics and structure employ existing tools and processes commonly used in the semiconductor and solid state sensor industries. In some aspects of these embodiments, the associated electronics and structure comprise read/write head electronics circuitry like that used in the practice of Scanning Tunneling Microscopy (STM) and Atomic Force Microscopy (AFM).

In some embodiments of the present invention, the at least one stylus comprises at least one array of styli.

In some embodiments of the present invention, the at least one stylus is laterally movable across a surface of the electric field programmable film. In some aspects of these embodiments, the at least one stylus is movable from one memory location to another memory location in the electric field programmable film.

In some embodiments of the present invention, the method for storing information in an electric field programmable film further comprises reading information written to the electric field programmable film. In some aspects of these embodiments, reading information written to the electric field programmable film comprises determining a force on a stylus biased at an electrostatic potential, wherein the stylus is 0-50 nm from the surface of the electric field programmable film. In some aspects of these embodiments, the stylus is 1-50 nm from the surface of the electric field programmable film. In some aspects of these embodiments, the stylus is 5-20 nm from the surface of the electric field programmable film. In some aspects of these embodiments, the stylus is 8-15 nm from the surface of the electric field programmable film.

In some embodiments of the present invention, the method for storing information in an electric field programmable film further comprises reading information written to the electric field programmable film, wherein the at least one stylus is a voltage biased stylus and wherein reading the information comprises determining a force on a voltage biased stylus. In some aspects of these embodiments, a destructive read is used. That is, when the information is read from the electric field programmable film the polarization of the memory locations is perturbed or destroyed (i.e., the information state of the memory locations following the information read may no longer be representative of the pre-read information state). In some aspects of these embodiments, the device is re-written following the information read to restore the device to its pre-read information condition. In some aspects of these embodiments, the voltage biased stylus is operated in tunneling mode or contact mode.

In some embodiments of the present invention, the method for storing information in an electric field programmable film comprises reading information written to an electric field programmable film. In some aspects of these embodiments, the magnitude of a force and the direction of that force (e.g., repulsive/attractive) imparted to a stylus are both indicative of the information state of the electric field programmable film. Each available information state in the electric field programmable film corresponds to a magnitude and a direction of a force. In some aspects of these embodiments, the force is measured in a proportional way using a force constant for a cantilever being used. In some aspects of these embodiments, the force is measured in direct current mode or in lock in amplifier mode as described in U.S. Patent No. 6,185,991. In some aspects of these embodiments, the electric field programmable film includes at least two available information states, wherein each available information state corresponds to a different polarization of the electric field programmable film. In some aspects of these embodiments, the electric field programmable film includes a first available information state and a second available information state, wherein the first available information state corresponds to a first polarization of the electric field programmable film and the second available information state corresponds to a second polarization of the electric field programmable film. In some aspects of these embodiments, the electric field programmable film includes at least three available information states, wherein each available information state corresponds to a different polarization of the electric field programmable film. In some aspects of these embodiments, the electric field programmable film includes a first available information state, a second available information state and a third available information state; wherein the first available information state corresponds to a first polarization of the electric field programmable film; wherein the second available information state corresponds to a second polarization of the electric field programmable film and wherein the third available information state corresponds to a third polarization of the electric field programmable film. In some aspects of these embodiments, the electric field programmable film includes at least four available information states, wherein each available information state corresponds to a different polarization of the electric field programmable film. In some aspects of these embodiments, the electric field programmable film includes a first available information state, a second available information state, a third available information state and a fourth available information state, wherein the first available information state corresponds to a first polarization of the electric field programmable film, wherein the second available information state corresponds to a second polarization of the electric field programmable film, wherein the third available information state corresponds to a third polarization of the electric field programmable film and wherein the fourth available information state corresponds to a fourth polarization of the electric field programmable film. One of ordinary skill in the art will recognize how to establish appropriate bands and dead zones to establish the various memory states for a particular electric field programmable film.

In some embodiments of the present invention, the program voltage is (a) high enough either (i) to induce an enduring polarization within the electric field programmable film, or (ii) to change the enduring polarization within the electric field programmable film to place the electric field programmable film into a different available information state; but (b) below a threshold voltage at which the electric field programmable film starts to conduct a current.

In some embodiments of the present invention, the method for storing information in an electric field programmable film memory device further comprises selecting an electric field programmable film composition from which the electric field programmable film is derived. In some aspects of these embodiments, the method comprises selecting an electric field programmable film composition from formulation A and formulation B; wherein formulation A comprises a binder, an electron donor and an electron acceptor; where at least one of the electron donor and the electron acceptor is chemically bound to the binder; and, wherein formulation B comprises a binder, an electron donor and an electron acceptor; wherein formulation B contains less than 0.05 wt% of at least one of the electron donor and the electron acceptor.

In some embodiments of the present invention, a method for storing information in an electric field programmable film is provided, comprising: providing a substrate, providing an electric field programmable film having a top surface and a bottom surface, wherein the bottom surface is electrically coupled to the substrate, wherein the electric field programmable film comprises one or more portions, wherein each portion corresponds to a memory location having at least two available information states, wherein each available information state corresponds to a different polarization of the electric field programmable film; providing at least one stylus; writing information to at least one memory location by applying a write voltage between the stylus and the substrate across the at least one memory location; wherein the write voltage induces an enduring polarization within the electric field programmable film. In some aspects of these embodiments, each memory location has at least three available information states. In some aspects of these embodiments, each memory location has at least four available information states. In some aspects of these embodiments, each memory location has three to eight available information states. In some aspects of these embodiments, each memory location has three to five available information states. In some aspects of these embodiments, each memory location has three available information states. In some aspects of these embodiments, each memory location has four available information states.

In some embodiments of the present invention, the substrate is conductive or semi-conductive. In some aspects of these embodiments, the substrate is conductive. In some aspects of these embodiments, the substrate is semi-conductive.

In some embodiments of the present invention, the at least one stylus comprises at least one of a conductive material and a semi-conductive material. In some aspects of these embodiments, the stylus is made of a conductive material. In some aspects of these embodiments, the stylus is made of a semi-conductive material.

In some embodiments of the present invention, the at least one stylus comprises a non-conductive material. In some aspects of these embodiments, the stylus is made of a non-conductive material.

In some embodiments of the present invention, there is provided a method for storing information in an electric field programmable film, comprising: providing a substrate; providing an electric field programmable film having a top surface and a bottom surface, wherein the bottom surface is electrically coupled to the substrate, wherein the electric field programmable film comprises one or more portions, wherein each portion corresponds to a memory location having at least two available information states, wherein each available information state corresponds to a different polarization of the electric field programmable film; providing at least one stylus; writing information to at least one memory location by bringing the stylus into proximity to, alternatively into contact with, the top surface of the electric field programmable film corresponding to the memory location and applying a voltage difference between the stylus and the substrate, wherein the magnitude of the voltage difference is high enough to induce an enduring polarization within the electric field programmable film. In some aspects of these embodiments, each memory location has at least three available information states. In some aspects of these embodiments, each memory location has three to eight available information states. In some aspects of these embodiments, each memory location has three available information states. In some aspects of these embodiments, each memory location has four available information states.

In some embodiments of the present invention, there is provided a method for storing multi-bit information in an electric field programmable film, comprising: providing a substrate; providing an electric field programmable film having a top surface and a bottom surface, wherein the bottom surface is electrically coupled to the substrate, wherein the electric field programmable film comprises one or more portions, wherein each portion corresponds to a memory location having at least three available information states; providing at least one voltage-biased conductive atomic force microscopy probe; writing information to at least one memory location by bringing the probe into proximity to, alternatively into contact with, the top surface of the electric field programmable film corresponding to the memory location and applying a voltage difference between the probe and the substrate, wherein the magnitude of the voltage difference is high enough to induce an enduring polarization within the electric field programmable film; wherein the electric field programmable film composition is selected from formulation A and formulation B; wherein formulation A comprises a binder, an electron donor and an electron acceptor; where at least one of the electron donor and the electron acceptor is chemically bound to the binder; and, wherein formulation B comprises a binder, an electron donor and an electron acceptor; wherein formulation B contains less than 0.05 wt% of at least one of the electron donor and the electron acceptor.

In some embodiments of the present invention, the electric field programmable film is used as a medium for mass information storage. In one aspect of this embodiment, the field programmable film has a thickness of 5 to 500 nm; or 10 to 200 nm; or 10 to 100 nm. In some aspects of this embodiment, the film is disposed on a conducting or semiconducting substrate.

In some embodiments of the present invention, there is provided a memory device, comprising: an electric field programmable film, wherein the electric field programmable film comprises a multiplicity of individual mapped portions corresponding to a multiplicity of individual memory locations; wherein information is stored as multi-bit information. In some aspects of these embodiments, the individual memory locations include at least three available information states. In some aspects of these embodiments, the individual memory locations include at least four available information states. In some aspects of these embodiments, the memory device further comprises at least one stylus. In some aspects of these embodiments, the at least one stylus and the electric field programmable film are repositionable relative to one another to facilitate at least one of reading and writing of a plurality of the individual memory locations. In some aspects of these embodiments, the memory device further comprises at least one array of styli, wherein the array of styli are operatively associated with the electric field programmable film such that information can be at least one of (i) written to and (ii) read from the electric field programmable film using the array of styli. In some aspects of these embodiments, the at least one array of styli is moveable relative to the electric field programmable film.

In some embodiments of the present invention, there is provided a memory device, comprising: an electric field programmable film, wherein the electric field programmable film comprises a multiplicity of individual mapped portions corresponding to a multiplicity of individual memory locations; wherein the memory device contains information stored in the individual memory locations using different polarizations to correspond to different available information states. In some aspects of these embodiments, the memory device further comprises at least one stylus. In some aspects of these embodiments, the at least one stylus and the electric field programmable film are repositionable relative to one another to facilitate at least one of reading and writing of a plurality of the individual memory locations. In some aspects of these embodiments, the memory device further comprises at least one array of styli, wherein the array of styli are operatively associated with the electric field programmable film such that information can be at least one of (i) written to and (ii) read from the electric field programmable film using the array of styli. In some aspects of these embodiments, the at least one array of styli is moveable relative to the electric field programmable film.

Some embodiments of the present invention will now be described in detail in the following Examples.

### Example 1: Binder Preparation

An 9-anthracenemethyl methacrylate/2-hydroxyethyl methacrylate copolymer binder was prepared according to the following procedure. A 500 ml, 3-necked round bottom flask was fitted with a condenser and gas inlet tube and purged with nitrogen for 15 minutes. The flask was then charged with degassed tetrahydrofuran (THF) (120 ml), 9-anthracenemethyl methacrylate (ANTMA, commercially available from Aldrich Chemical Co., Milwaukee, WI.) (10.0 grams, 36.2 mmol) and 2-hydroxyethyl methacrylate (HEMA) (9.3 ml, 10.0 grams, 76.8 mmol), with agitation. To this mixture was then added 1,1'-azobis-(cyclohexane carbonitrile) (commercially available from Du Pont as VAZO 88) (0.57 grams, 2.33 mmol, 2.85 % w/w), with agitation. The flask contents were then heated to reflux. After refluxing for 24 hours, an additional portion of 1,1'-azobis-(cyclohexane carbonitrile) (0.89 grams, 3.64 mmol, 4.45 % w/w) was added. The flask contents were then refluxed for another 24 hours. The flask contents were then cooled to room temperature. The contents of the flask were then poured into 500 ml of a hexane/ethyl ether solution containing 20 volume percent of hexane in ethyl ether to precipitate the binder. The solid binder was collected by suction filtration and dried in vacuo to yield 19.5 g (98%) as a fluffy white solid.

### Example 2: Electric Field Programmable Film Composition Preparation

An electric field programmable film composition was prepared by dissolving together the binder from **Example 1** (0.884 g); a crosslinker (0.111 g, Powderlink 1174 glycouryl crosslinker from Cytec Industries); a catalyst (0.005 g, p-toluenesulfonic acid monohydrate (PTSA) from Aldrich Chemical Co.); an electron acceptor (0.216 mg, C₆₀-Buckminsterfullerene from Aldrich Chemical Co.); and a solvent (24 g, 50/50 w/w blend of methoxybenzene and 2-heptanone). After dissolution, solution was filtered through a polypropylene filter with a 0.2 µm pore size to collect the product electric field programmable film composition.

### Example 3: Electric Field Programmable Film Preparation

An electric field programmable film was fabricated by spin coating the product of **Example 2** on a p-type silicon wafer having a diameter of 100 millimeters and a resistivity of about 0.0001 to about 0.1 ohm-cm at a spin speed from about 2,500 rpm. The coated silicon wafer was then baked on a hotplate at 250°C for 60 seconds to give an electric field programmable film having a thickness of about 50 nm.

### Example 4: Writing Information

A coupon of 7mm by 7mm was cleaved from the coated silicon wafer of **Example 3**. The coupon was cemented to the surface of a magnetic mounting disk with silver paste. The resulting sample was placed in a Veeco Multimode atomic force microscope with a Nanoscope IV controller. The atomic force microscope was outfitted with a cantilever/stylus combination with a nominal force constant of 3.0 N/m and a nominal resonant frequency of 75 kHz. The stylus was constructed of gold coated silicon. As mounted in the atomic force microscope, the bottom of the sample, and thus the bottom surface of the electric field programmable film, was constrained to be at ground potential. The electric field programmable film included three available information states. Information was then written to a plurality of memory locations in the electric field programmable film by creating an enduring domain of polarization (corresponding to one of the three available information states) within the electric field programmable film by selectively imparting a DC bias voltage of -2.0 V, -0.6 V or 0 V onto the stylus and touching the stylus to the top surface of the electric field programmable film corresponding to a given memory location to write the given memory location into information state 1, 2 or 3, respectively. During this information storing process, no appreciable current was observed to flow through the stylus.

### Example 5: Reading Information

The information stored in the electric field programmable film in **Example 4** was read using a Veeco Multimode atomic force microscope with a Nanoscope IV controller outfitted with a cantilever/stylus combination as described in **Example 4**. Specifically, a DC bias voltage of +5.0 V was imparted on the tip, which was then passed over the electric field programmable film at a fly height (distance from the film) of 10 nm. The Veeco Multimode atomic force microscope was able to read the information stored in the plurality of memory locations in the electric field programmable film by measuring the electrostatic repulsion imparted on the positively biased stylus. The electrostatic repulsion imparted on the positively biased stylus was indicative of the information state written in a given memory location.

## Claims

1. A method for storing information in an electric field programmable film, comprising:
providing an electric field programmable film having a top surface and a bottom surface,
writing information to the electric field programmable film by applying a write voltage across the electric field programmable film from the top surface to the bottom surface using at least one stylus,
wherein the write voltage induces an enduring domain of polarization within the electric field programmable film; and,
wherein the electric field programmable film includes at least two available information states, where each available information state corresponds to a different polarization.

2. A method for storing information in an electric field programmable film device, comprising:
providing a substrate;
providing an electric field programmable film having a top surface and a bottom surface, wherein the bottom surface is electrically coupled to the substrate, wherein the electric field programmable film comprises one or more portions, wherein each portion corresponds to a memory location having at least two available information states, wherein each available information state corresponds to a different polarization of the electric field programmable film;
providing at least one stylus;
writing information to at least one memory location by applying a write voltage between the stylus and the substrate at the at least one memory location, wherein the write voltage induces an enduring domain of polarization within the electric field programmable film.

3. The method of claim 2, wherein the at least one stylus is an array of styli.

4. The method of claim 2, further comprising reading information written to the electric field programmable film, wherein reading the information comprises determining a force on a stylus.

5. The method of claim 2, wherein each memory location has at least three available information states and wherein information is written to the at least one memory location as multi-bit information.

6. A memory device, comprising:
an electric field programmable film, wherein the electric field programmable film comprises a multiplicity of individual mapped portions corresponding to a multiplicity of individual memory locations; wherein the memory device contains information stored as multi-bit information.

7. The memory device of claim 6, further comprising at least one stylus.

8. The memory device of claim 7, wherein the at least one stylus and the electric field programmable film are repositionable relative to one another to facilitate at least one of reading and writing of the multiplicity of individual memory locations.

9. The memory device of claim 6, further comprising at least one array of styli, wherein the array of styli are operatively associated with the electric field programmable film such that information can be at least one of programmed to and read from the memory device using the array of styli.

10. A method for reading information stored in an electric field programmable film, comprising:
providing an electric field programmable film containing information stored in at least one memory location, wherein the electric field programmable film includes at least two available information states, where each available information state corresponds to a different polarization;
providing at least one stylus;
determining the information state of at least one memory location by measuring the force between the stylus and the electric field programmable film corresponding to the at least one memory location.
